# EUROPEAN PATENT SPECIFICATION

(11) **EP 2 139 050 B1**
(45) Date of publication and mention of the grant of the patent: **21.12.2011**
(21) Application number: 09163487.3
(22) Date of filing: 23.06.2009
(51) Int. Cl.: H01L 31/18, H01L 31/048

(54) **Method for the production of a solar panel and semi-product**
Verfahren zur Herstellung eines Sonnenkollektors und Halbfabrikat
Procédé de production d'un panneau solaire et semi-produit

(30) Priority: 26.06.2008 NL 2001727
(43) Date of publication of application: 30.12.2009
(73) Proprietor: Eurotron B.V., 2971 VL Bleskensgraaf (NL)
(72) Inventor: Bakker, Jan, 2971 BG Bleskensgraaf (NL); Verschoor, Abraham Jan, 3366 BG Wijngaarden (NL); den Hartigh, Simon, 2969 BG Oud Alblas (NL)
(74) Representative: Nollen, Maarten Dirk-Johan

(56) References cited:
- WO-A-94/22172
- US-A- 4 154 998
- US-A- 4 836 861
- US-A1- 2007 193 618

## Description

The invention relates to the production of solar panels which comprise an array of jointly connected solar cells. Such solar cells or photovoltaic cells are optoelectronic devices by means of which radiation can be converted into electrical current. The cells generally consist of crystalline silicon and are jointly connected by an electrical circuit. That electrical circuit is connected to the contacts of each solar cell. An embodiment is known wherein those contacts are arranged on the front side of the solar cell. In such an embodiment, the electrical circuit, for example in the form of electrically conductive strips of material, is arranged on the front side of the solar panel. A drawback of that embodiment is that a portion of the surface of the panel is occupied by the electrical circuit and therefore cannot be used for the photovoltaic conversion.

Further to this, solar cells are known wherein the contacts are arranged on the back side. The electrical circuit is therefore also arranged on the back side, so that a larger portion of the available surface of the solar panel remains available for the photovoltaic conversion.

Solar panels of these types can be produced in various ways. It is known from US patent 5.972.732 that a solar panel can be formed consecutively from a layer of foil, an electrically conductive layer, an array of solar cells, followed again by a layer of foil and finally a sturdy light translucent panel, such as a glass panel. Such a package is heated in a kiln, thereby curing the layer of foil, which usually consists of ethylene vinyl acetate. Document US-A-4 154 998 discloses another method to form a solar panel.

Before the solar panel is ready after heating and curing the foil layers, however, the various components thereof are arranged in a package in a relatively loosely stacked position with respect to one another. In this state, the package needs to be treated very carefully since relative displacement of the components may otherwise occur. If the various components are dislocated, however, the end-product will be faulty, thus resulting in the malfunction of the electrical contacts. It is also inevitable that the package is subjected to certain displacements during transport, as it is transferred from the assembly station to a kiln for the final production of the solar panel.

The object of the invention is therefore to provide a method for the production of solar panels as referred to in the foregoing, wherein the risk of dislocation of the different components in a package is prevented. This object is achieved by a method for the production of a solar panel with a plurality of solar cells, comprising the steps of:
- providing a package, respectively comprising a backing foil with a pattern of electrically conductive wires and which is provided with a thermally activated adhesive, a lower layer of fusible foil, such as ethylene vinyl acetate (EVA), provided on the lower side of the layer of foil to which the adhesive layer is applied, an array of solar cells, the contacts of which are connected to or which can be connected to the electrically conductive wires on the backing foil, an upper layer of fusible foil provided on top of the array of solar cells, such as EVA, and a light translucent panel,
- placing the package in an auxiliary heating station
- heating the package in an auxiliary heating station so that the package is fixed;
- the subsequent transfer of the fixed package to a primary heating station.

In the method according to the invention, the various components from the package that must be formed to compose the solar panel are fixed at an early stage with respect to one another by heating at a moderately high temperature. This fixation process may take place, for example, on the workbench where the package is assembled. The package thus fixed can then be finished, without the risk of displacement of the various components with respect to one another, in a kiln or laminator, whereupon the finished solar panel is obtained. The temperature at which the package is fixed is for example approx. 120°C, whereas the temperature at which the package is formed to produce a finished solar panel is, for example, approx. 150°C. In particular, the fixation of the package in the auxiliary heating station can be performed under atmospheric pressure or ambient pressure.

The method according to the invention can be applied to the production of different types of solar panels. Specifically, but not exclusively, the method can be applied to the production of a solar panel wherein the contacts of the individual solar cells are arranged on the back side thereof, so that a relatively large photovoltaic surface is obtained. In that case the method according to the invention comprises the steps of:
- providing a layer of EVA with holes on the foil,
- providing quantities of electrically conductive adhesive to the backing foil,
- applying the EVA layer in such a manner that the holes coincide with the quantities of adhesive material applied to the backing foil,
- the electrical connection of the contacts provided on the solar cells with the electrically conductive wires on the foil via the quantities of electrically conductive adhesive applied in the holes in the layer of EVA.

The electrical connection between the contacts of the individual solar cells and the electrically conductive foil is now established by the electrically conductive adhesive layer in the holes of the EVA layer. However, alternatively, the method may also be applied for the production of solar panels constructed in the traditional manner, whereby the contacts of the solar cells are attached to electrically conductive strips by soldering means. These strips may be applied either on the back side or the front side of the solar cells.

The invention further relates to a semi-product for use in the method as described in the foregoing, respectively comprising a backing foil with a pattern of electrically conductive wires and which is provided with a thermally activated adhesive, a fusible foil, such as ethylene vinyl acetate (EVA), provided on the side of the layer of foil to which the adhesive layer is applied, an array of solar cells, a layer of fusible foil, such as EVA, and a translucent panel, wherein the semi-product has been subjected to an increased temperature at atmospheric pressure.

According to a first embodiment, the thermally activated adhesive layer can be electrically conductive. The EVA layer bordering on said adhesive layer has holes, while the electrical contacts formed on the solar cells are connected via the holes with the electrically conductive adhesive layer and the foil. Alternatively, the contacts of the solar cells can be soldered to the electrically conductive strips. According to a first optional embodiment, in this case the contacts of the solar cells and the electrically conductive strips may be arranged on the front side of the solar cells. According to a second optional embodiment, the contacts of the solar cells and the electrically conductive strips may be arranged on the back side of the solar cells.

The invention will now be described in more detail with reference to the exemplary embodiment shown in the figures.
Figure 1 shows a side view of an arrangement for implementing the method according to the invention.
Figure 2 shows a top view.
Figure 3 shows an exploded cross-sectional view through a package for use in the arrangement shown in figures 1 and 2.
Figure 4 shows a bottom view of a solar panel.
Figure 5 shows the various steps of the method according to the invention.

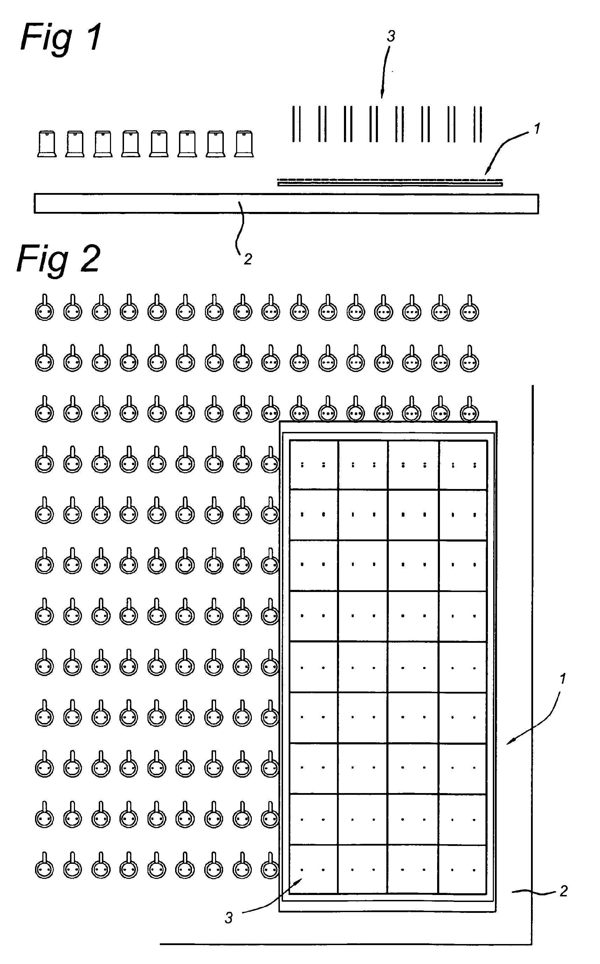

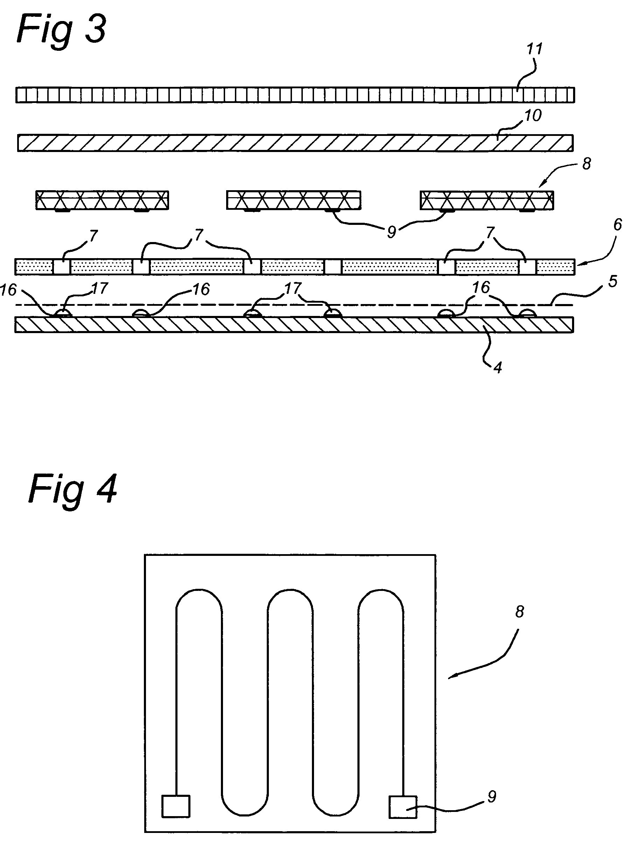

The arrangement depicted in figures 1 and 2 shows a package 1, the arrangement of which will be described in more detail with reference to figure 3. This package is placed on a workbench 2. A battery of heating equipment 3 is arranged above the package.

As shown in figure 3, the package comprises, from bottom to top, a backing foil 4 applied to the back side, upon which a pattern of electrically conductive wires 16 is applied. Adhesive points or adhesive dots 17 are applied to the electrically conductive wires 16. A layer of ethylene vinyl acetate 6 then follows, provided with holes 7. An adhesive point or adhesive dot comprising electrically conductive adhesive material 17 is very precisely applied in and around the holes 7. This electrically conductive adhesive can be a quick-setting silver-based adhesive, or a soldering paste.

An array of solar cells 8 with electrical contacts 9 (see also figure 4) on the lower side is arranged on top of the ethylene vinyl acetate 6, each of which are aligned with respect to a hole 7 in the layer 6. A further layer of ethylene vinyl acetate 10 is applied on top of the solar cells 8, whilst the uppermost layer is formed by a glass panel.

In the arrangement shown in the figures 1 and 2, these various components are laid on top of one another so that there are no openings or gaps in between. In this state, the package 1 is heated to 120°C, for example, so that the electrically conductive and thermally activated adhesive 17 is activated. This causes adhesion in the package, while the electrical contacts 9 are brought conductively into contact with the electrically conductive wires 16 on the backing foil 4. An ambient pressure or atmospheric pressure preferably prevails in the auxiliary heating station where this fixation process is carried out.

Upon cooling, the package 1 is fixed in such a manner that a semi-product 13 is formed and this can then be transported without the risk of relative dislocation of the various components occurring. The semi-product 13 can be transferred to a kiln, for example, in order to cure the layers of ethylene vinyl acetate 6, 10 and to produce a finished solar panel 15. This curing process may take place in the usual manner under overpressure.

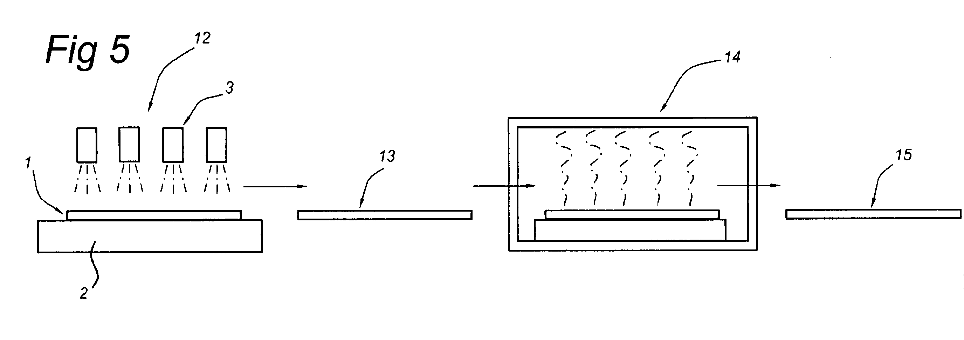

Figure 5 is a schematic representation of the process of the method according to the invention. In the heating station 12, the package 1 is fixed on the workbench 2 under the effects of heat originating from the battery of heating equipment 3, for example to a temperature of 120°C. A period of less than a second up to several tens of seconds is sufficient to achieve the desired degree of fixation. The semi-product 13 thus obtained, the components of which are firmly fixed to prevent dislocation, is then fed into the kiln 14 without any difficulty.

A semi-product 13 is then heated further in the kiln 14 to a temperature of 150°C, for example, and then subjected to an overpressure. After some time, whilst maintaining heating and overpressure, for example between 5-7 minutes, the adhesion between the different parts is formed, after which the finished solar panel 15 is obtained.

### List of reference numerals

- 1.: Package
- 2.: Mold table/bench
- 3.: Battery of heating equipment
- 4.: Backing foil
- 6.: Lower layer of ethylene vinyl acetate
- 7.: Hole in layer
- 8.: Solar cell
- 9.: Solar cell contact
- 10.: Upper layer of ethylene vinyl acetate
- 11.: Glass panel
- 12.: Heating station
- 13.: Semi-product
- 14.: Kiln
- 15.: Solar panel
- 16.: Electrically conductive wire
- 17.: Electrically conductive adhesive material

## Claims

1. Method for the production of a solar panel (15) with a plurality of solar cells (8), comprising the steps of:
- providing a package (1), respectively comprising a backing foil (4) with a pattern of electrically conductive wires (16) and which is provided with a thermally activated adhesive (17), a lower layer of fusible foil, such as ethylene vinyl acetate (EVA) (6), provided on the side of the layer of the backing foil to which the adhesive (17) is applied, an array of solar cells (8), the contacts (9) of which are connected to or can be connected to the electrically conductive wires (16) on the backing foil (4), an upper layer of fusible foil, such as EVA (10), provided on the array of solar cells (8), and a translucent panel (11),
- placing the package (1) in an auxiliary heating station (12),
- heating the package (1) in an auxiliary heating station (12) so that the package (1) is fixed,
- the subsequent transfer of the fixed package (13) to a primary heating station (14).

2. Method according to claim 1, comprising the steps of:
- heating the fixed package (13) in the primary heating station (14), and subjecting said fixed package (13) to an overpressure,
- cooling the package (13) and the relief of the overpressure for forming a solar panel,
- removing the finished solar panel (15) from the primary heating station (14).

3. Method according to claim 1 or 2, comprising the step of:
- cooling the fixed package (13) after removal thereof from the auxiliary heating station (12).

4. Method according to any of the preceding claims, wherein said package is heated in the auxiliary heating station (12) for a period of less than a second up to several tens of seconds.

5. Method according to any of the preceding claims, wherein said package is heated in the primary heating station (14) for a period of several minutes, for example 5-7 minutes.

6. Method according to any of the preceding claims, comprising the steps of:
- providing a layer of EVA (6) with holes (7) on the backing foil (4),
- applying quantities of electrically conductive adhesive material (17) to the backing foil (4),
- applying the EVA layer (6) in such a manner that the holes (7) coincide with the quantities of adhesive material on the backing foil (4),
- forming the electrical connection of the contacts (9) provided on the solar cells (8) with the electrically conductive wires (16) on the backing foil (4) via the quantities of electrically conductive adhesive (17) applied in the holes (7) in the layer of EVA.

7. Method according to claim 6, comprising the step of providing contacts and the electrically conductive wires soldered thereto to the back side of the solar cells.

8. Method according to claim 6, comprising the step of providing contacts and the electrically conductive wires soldered thereto to the front side of the solar cells.

9. Method according to any of the preceding claims, comprising the step of:
- heating of the package (1) in the auxiliary heating station (12) under atmospheric pressure or ambient pressure.

10. A semi-manufactured package (10) for use in the method as described in the foregoing claims 1-9, comprising, as components of the package:
- a backing foil (4) with a pattern of electrically conductive wires (16) and which is provided with a thermally activated adhesive (17),
- a layer of fusible foil (6) provided on the side of the layer of foil to which the adhesive (17) is applied,
- an array of solar cells (8),
- a further layer of fusible foil on top of the solar cells (8) (10), and
- a translucent panel (11),
wherein the semi-product (13) has been subjected to an increased temperature under atmospheric pressure, such that the components of the package are fixed to prevent dislocation and can be transported and/or fed into a primary heating station.

11. Semi-product according to claim 10, wherein the layer of EVA material (6) bordering on the thermally activated adhesive (17) is provided with holes (7) and the electrical contacts (9) provided on the solar cells (8) via quantities of adhesive material applied in the holes are connected with the electrically conductive wires (16) on the backing foil (4).

12. Semi-product according to claim 10, wherein the contacts of the solar cells are soldered to the electrically conductive wires.

13. Semi-product according to claim 12, wherein the contacts of the solar cells and the electrically conductive wires are arranged on the front side of the solar cells.

14. Semi-product according to claim 12, wherein the contacts of the solar cells and the electrically conductive wires are arranged on the back side of the solar cells.

15. A system for the production of a solar panel with a plurality of solar cells (8), comprising:
- an assembly station for assembly of a package comprising a backing foil (4) with a pattern of electrically conductive wires (16) and which is provided with a thermally activated adhesive (17), a layer of fusible foil (6) provided on the side of the layer of foil to which the adhesive (17) is applied and comprising holes (7), an array of solar cells (8) provided with contacts connected via the holes to the electrically conductive adhesive layer and the foil, a further layer of fusible foil on top of the solar cells (8) (10), and a translucent panel (11),
- an auxiliary heating station for fixation of the package,
- transportation means for transfer of the fixed package, and
- a primary heating station for forming the package so as to produce the finished solar panel.

## Patentansprüche

1. Verfahren zum Herstellen eines Sonnenkollektors (15) mit einer Mehrzahl an Solarzellen (8), aufweisend die folgenden Schritte:
- Bereitstellen einer Einheit (1), welche jeweils eine Unterfolie (4), die eine Struktur aus elektrisch leitenden Drähten (16) aufweist und die mit einem thermisch aktivierten Klebstoff (17) versehen ist, eine untere Schicht aus einer schmelzbaren Folie, wie beispielsweise Ethylenvinylacetat (EVA) (6), die auf der Seite der Schicht der Unterfolie vorhanden ist, auf welche der Klebstoff (17) aufgebracht ist, eine Anordnung Solarzellen (8), deren Kontakte (9) mit elektrisch leitenden Drähten (16) auf der Unterfolie (4) verbunden sind oder verbindbar sind, eine obere Schicht einer schmelzbaren Folie, wie beispielsweise EVA (10), die auf der Anordnung Solarzellen (8) vorhanden ist, und eine lichtdurchlässige Platte (11) aufweist,
- Anordnen der Einheit (1) in einer Hilfs-Heizstation (12),
- Erhitzen der Einheit (1) in der Hilfs-Heizstation (12), so dass die Einheit (1) fixiert wird,
- anschließendes Transportieren der fixierten Einheit (13) zu einer primären Heizstation (14).

2. Verfahren nach Anspruch 1, aufweisend die folgenden Schritte:
- Erhitzen der fixierten Einheit (13) in der primären Heizstation (14) und Unterziehen der fixierten Einheit (13) einem Überdruck,
- Kühlen der Einheit (13) und Entspannen des Überdrucks zum Ausbilden eines Sonnenkollektors,
- Entfernen des fertig gestellten Sonnenkollektors (15) aus der primären Heizstation (14).

3. Verfahren nach Anspruch 1 oder 2, aufweisend die folgenden Schritte:
- Kühlen der fixierten Einheit (13) nach ihrem Entfernen aus der Hilfs-Heizstation (12).

4. Verfahren nach einem der vorstehenden Ansprüche, wobei die Einheit in der Hilfs-Heizstation (12) über eine Periode erhitzt wird, die weniger als eine Sekunde bis zu mehreren zehn Sekunden beträgt.

5. Verfahren nach einem der vorstehenden Ansprüche, wobei die Einheit in der primären Heizstation (14) über eine Periode von mehreren Minuten erhitzt wird, beispielsweise 5 bis 7 Minuten.

6. Verfahren nach einem der vorstehenden Ansprüche, aufweisend die folgenden Schritte:
- Bereitstellen einer Schicht EVA (6) mit Löchern (7) auf der Unterfolie (4),
- Aufbringen von Mengen an elektrisch leitendem Klebstoffmaterial (17) auf die Unterfolie (4),
- Aufbringen der EVA-Schicht (6) auf eine solche Weise, dass die Löcher (7) mit den Mengen an Klebstoffmaterial auf der Unterfolie (4) zusammenfallen,
- Ausbilden der elektrischen Verbindung der Kontakte (9), die auf den Solarzellen (8) vorhanden sind, mit den elektrisch leitenden Drähten (16) auf der Unterfolie (4) über die Mengen an elektrisch leitendem Klebstoff (17), der in den Löchern (7) in der Schicht EVA aufgebracht ist.

7. Verfahren nach Anspruch 6, aufweisend den Schritt des Bereitstellens von Kontakten und der elektrisch leitenden Drähte, die daran gelötet sind, auf der Rückseite der Solarzellen.

8. Verfahren nach Anspruch 6, aufweisend den Schritt des Bereitstellens von Kontakten und der elektrisch leitenden Drähte, die daran gelötet sind, auf der Vorderseite der Solarzellen.

9. Verfahren nach einem der vorstehenden Ansprüche, aufweisend den folgenden Schritt:
- Erhitzen der Einheit (1) in der Hilfs-Heizstation (12) unter atmosphärischem Druck oder Umgebungsdruck.

10. Einheit (10) als Halbfabrikat zur Verwendung im Verfahren gemäß den vorstehenden Ansprüchen 1 bis 9, wobei sie als Komponenten der Einheit Folgendes aufweist:
- eine Unterfolie (4), die eine Struktur aus elektrisch leitenden Drähten (16) aufweist und die mit einem thermisch aktivierten Klebstoff (17) versehen ist,
- eine Schicht einer schmelzbaren Folie (6), die auf der Seite der Schicht der Folie vorhanden ist, auf welcher der Klebstoff (17) aufgebracht ist,
- eine Anordnung Solarzellen (8),
- eine weitere Schicht einer schmelzbaren Folie auf den Solarzellen (8) (10), und
- eine lichtdurchlässige Platte (11),
wobei das Halbfabrikat (13) einer erhöhten Temperatur unter atmosphärischem Druck ausgesetzt wurde, so dass die Komponenten der Einheit fixiert sind, um eine Lageverschiebung zu verhindern, und um in eine primäre Heizstation transportiert und/oder in diese eingebracht werden zu können.

11. Halbfabrikat nach Anspruch 10, wobei die Schicht aus EVA-Material (6), welche an den thermisch aktivierten Klebstoff (17) grenzt, mit Löchern (7) versehen ist, und die elektrischen Kontakte (9), welche auf den Solarzellen (8) über Mengen des Klebstoffmaterials vorhanden sind, das in den Löchern aufgebracht ist, mit den elektrisch leitenden Drähten (16) auf der Unterfolie (4) verbunden sind.

12. Halbfabrikat nach Anspruch 10, wobei die Kontakte der Solarzellen an die elektrisch leitenden Drähte gelötet sind.

13. Halbfabrikat nach Anspruch 12, wobei die Kontakte der Solarzellen und die elektrisch leitenden Drähte auf der Vorderseite der Solarzellen angeordnet sind.

14. Halbfabrikat nach Anspruch 12, wobei die Kontakte der Solarzellen und die elektrisch leitenden Drähte auf der Rückseite der Solarzellen angeordnet sind.

15. System für die Herstellung eines Sonnenkollektors mit einer Mehrzahl an Solarzellen (8), aufweisend:
- eine Montagestation für den Zusammenbau einer Einheit, welche eine Unterfolie (4), die eine Struktur aus elektrisch leitenden Drähten (16) aufweist und die mit einem thermisch aktivierten Klebstoff (17) versehen ist, eine Schicht einer schmelzbaren Folie (6), die auf der Seite der Schicht der Folie vorhanden ist, auf welcher der Klebstoff (17) aufgebracht ist, und die Löcher (7) umfasst, eine Anordnung von Solarzellen (8), die mit Kontakten versehen sind, welche über die Löcher mit der elektrisch leitenden Klebstoffschicht und der Folie verbunden sind, eine weitere Schicht einer schmelzbaren Folie auf den Solarzellen (8) (10) und eine lichtdurchlässige Platte (11) aufweist,
- eine Hilfs-Heizstation für die Fixierung der Einheit,
- Transportmittel zum Transportieren der fixierten Einheit und
- eine primäre Heizstation zum Ausbilden der Einheit so, dass der fertig gestellte Sonnenkollektor erzeugt wird.

## Revendications

1. Procédé pour produire un panneau solaire (15) avec une pluralité de cellules solaires (8) comprenant les étapes consistant à :
prévoir un boîtier (1) comprenant respectivement une feuille de renforcement (4) avec un modèle de fils électriquement conducteurs (16) et qui est prévue avec un adhésif thermoactif (17), une couche inférieure de feuille fusible telle que l'éthylène-acétate de vinyle (EVA) (6), prévue sur le côté de la couche de la feuille de renforcement sur laquelle l'adhésif (17) est appliqué, un réseau de cellules solaires (8), dont les contacts (9) sont raccordés à ou peuvent être raccordés aux fils électriquement conducteurs (16) sur la feuille de renforcement (4), une feuille supérieure de la feuille fusible, telle que l'EVA (10), prévue sur le réseau de cellules solaires (8) et un panneau translucide (11),
placer le boîtier (1) dans une station de chauffage auxiliaire (12),
faire chauffer le boîtier (1) dans une station de chauffage auxiliaire (12) de sorte que le boîtier (1) est fixé,
transférer successivement le boîtier fixé (13) à une station de chauffage principale (14).

2. Procédé selon la revendication 1, comprenant les étapes consistant à :
faire chauffer le boîtier fixé (13) dans la station de chauffage principale (14), et soumettre ledit boîtier fixé (13) à une surpression,
faire refroidir le boîtier (13) et la décharge de la surpression pour former un panneau solaire,
retirer le panneau solaire (15) fini de la station de chauffage principale (14).

3. Procédé selon la revendication 1 ou 2, comprenant l'étape consistant à:
faire refroidir le boîtier fixé (13) après son retrait de la station de chauffage auxiliaire (12).

4. Procédé selon l'une quelconque des revendications précédentes, dans lequel ledit boîtier est chauffé dans la station de chauffage auxiliaire (12) pendant une période inférieure à une seconde jusqu'à plusieurs dizaines de secondes.

5. Procédé selon l'une quelconque des revendications précédentes, dans lequel ledit boîtier est chauffé dans la station de chauffage principale (14) pendant une période de plusieurs minutes, par exemples 5 à 7 minutes.

6. Procédé selon l'une quelconque des revendications précédentes, comprenant les étapes consistant à :
prévoir une couche d'EVA (6) avec des trous (7) sur la feuille de renforcement (4),
appliquer des quantités de matériau adhésif électriquement conducteur (17) sur la feuille de renforcement (4),
appliquer la couche d'EVA (6) de sorte que les trous (7) coïncident avec les quantités de matériau adhésif sur la feuille de renforcement (4),
former le raccordement électrique des contacts (9) prévus sur les cellules solaires (8) avec les fils électriquement conducteurs (16) sur la feuille de renforcement (4) via les quantités d'adhésif électriquement conducteur (17) appliqué dans les trous (7) dans la couche d'EVA.

7. Procédé selon la revendication 6, comprenant l'étape consistant à prévoir des contacts et les fils électriquement conducteurs soudés à ces derniers sur le côté arrière des cellules solaires.

8. Procédé selon la revendication 6, comprenant l'étape consistant à prévoir des contacts et les fils électriquement conducteurs soudés à ces derniers sur le côté avant des cellules solaires.

9. Procédé selon l'une quelconque des revendications précédentes, comprenant l'étape consistant à :
chauffer le boîtier (1) dans la station de chauffage auxiliaire (12) à la pression atmosphérique ou la pression ambiante.

10. Boîtier semi-fini (10) destiné à être utilisé dans le procédé tel que décrit dans les revendications 1 à 9 précédentes, comprenant, en tant que composants du boîtier :
une feuille de renforcement (4) avec un modèle de fils électriquement conducteurs (16) et qui est prévue avec un adhésif thermoactif (17),
une couche de feuille fusible (6) prévue sur le côté de la couche de feuille sur laquelle l'adhésif (17) est appliqué,
un réseau de cellules solaires (8),
une autre couche de feuille fusible sur la partie supérieure des cellules solaires (8) (10), et
un panneau translucide (11),
dans lequel le demi-produit (13) a été soumis à une température augmentée sous pression atmosphérique, de sorte que les composants du boîtier sont fixés pour empêcher la dislocation et peuvent être transportés et/ou alimentés dans une station de chauffage principale.

11. Demi-produit selon la revendication 10, dans lequel la couche d'EVA (6) bordant l'adhésif thermoactif (17) est prévue avec des trous (7) et des contacts électriques (9) prévus sur les cellules solaires (8) via des quantités de matériau adhésif appliqué dans les trous sont raccordés avec les fils électriquement conducteurs (16) sur la feuille de renforcement (4).

12. Demi-produit selon la revendication 10, dans lequel les contacts des cellules solaires sont soudés aux fils électriquement conducteurs.

13. Demi-produit selon la revendication 12, dans lequel les contacts des cellules solaires et les fils électriquement conducteurs sont agencés sur le côté avant des cellules solaires.

14. Demi-produit selon la revendication 12, dans lequel les contacts des cellules solaires et les fils électriquement conducteurs sont agencés sur le côté arrière des cellules solaires.

15. Système pour la production d'un panneau solaire avec une pluralité de cellules solaires (8), comprenant :
une station d'assemblage pour assembler un boîtier comprenant une feuille de renforcement (4) avec un modèle de fils électriquement conducteurs (16) et qui est prévue avec un adhésif thermoactif (17), une couche de feuille fusible (6) prévue sur le côté de la couche de feuille sur laquelle l'adhésif (17) est appliqué et comprenant des trous (7), un réseau de cellules solaires (8) prévues avec des contacts raccordés via les trous sur la couche adhésive électriquement conductrice et la feuille, une autre couche de feuille fusible sur la partie supérieure des cellules solaires (8) (10), et un panneau translucide (11),
une station de chauffage auxiliaire pour la fixation du boîtier,
des moyens de transport pour le transfert du boîtier fixé, et
une station de chauffage principale pour former le boîtier afin de produire le panneau solaire fini.
